# FASCICULE DE BREVET EUROPEEN

(11) **EP 0 738 038 B1**
(45) Date de publication et mention de la délivrance du brevet: **18.09.2002**
(21) Numéro de dépôt: 96410032.5
(22) Date de dépôt: 09.04.1996
(51) Int. Cl.: H03F 3/08

(54) **Amplificateur de courant**
Stromverstärker
Current amplifier

(30) Priorité: 11.04.1995 FR 9504609
(43) Date de publication de la demande: 16.10.1996
(73) Titulaire: STMicroelectronics S.A., 92120 Montrouge (FR)
(72) Inventeur: Dell'Ova, Francis, 38660 Saint Hilaire du Touvet (FR); Bonhoure, Bruno, 38100 Grenoble (FR); Paillardet, Frédéric, 38000 Grenoble (FR)
(74) Mandataire: de Beaumont, Michel

(56) Documents cités:
- EP-A- 0 306 798
- EP-A- 0 383 397
- WO-A-92/19039
- DE-A- 3 140 956
- US-A- 3 801 933
- US-A- 4 507 573
- US-A- 5 216 386
- A.B.Grebene: "Bipolar and MOS analog integrated circuit design", pages 273, 274, J.Wiley and sons, New York, 1984

## Description

La présente invention concerne un amplificateur de courant, destiné notamment à amplifier des courants de faible valeur avec une grande bande passante.

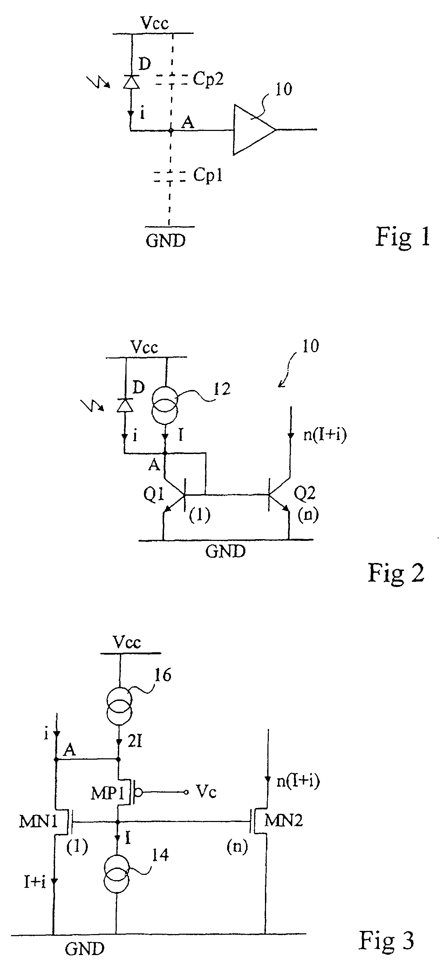

La figure 1 représente un tel amplificateur de courant dans une application classique. Le courant à amplifier i est fourni à une entrée A de l'amplificateur par une photodiode D reliée à un potentiel d'alimentation Vcc. Lorsque cette photodiode D est, par exemple, l'une de celles d'une tête de lecture de disque laser, les variations d'intensité lumineuse, et donc les variations du courant dans la diode D, sont particulièrement faibles. La valeur maximale du courant i est de l'ordre de 3 microampères. En outre, ce courant i est susceptible de varier à une fréquence de l'ordre de 1,5 mégahertz.

Une capacité parasite Cp1 est présente entre l'entrée A de l'amplificateur 10 et la masse GND, et une capacité parasite Cp2 est présente entre l'entrée A et le potentiel d'alimentation Vcc. Ces deux capacités parasites risquent de considérablement réduire la bande passante de l'amplificateur 10 et d'injecter dans l'entrée du bruit provenant des tensions d'alimentation. Pour éviter ces inconvénients, il est indispensable de réduire l'impédance d'entrée de l'amplificateur 10 ou, en d'autres termes, de rendre le potentiel de cette entrée aussi stable que possible.

La figure 2 représente un exemple d'amplificateur de courant classique fournissant des résultats satisfaisants pour une photodiode de tête de lecture de disque laser.

En fait, l'amplificateur de courant 10 est un miroir de courant à transistors bipolaires. Un transistor NPN Q1 forme le transistor d'entrée du miroir de courant. Son émetteur est relié à la masse GND et sa base et son collecteur reçoivent le courant à amplifier i provenant de la photodiode D. En outre, une source de courant constant 12, reliée en parallèle sur la diode D, fournit un courant de polarisation I. Un transistor NPN Q2, formant un transistor de sortie du miroir de courant, est relié en parallèle par sa base et son émetteur sur le transistor Q1. Le courant de sortie de l'amplificateur est prélevé sur le collecteur du transistor Q2. Les surfaces d'émetteur des transistors Q1 et Q2 sont indiquées entre parenthèses. Le transistor Q1 a une surface unitaire et le transistor Q2 une surface n. Ainsi, le courant i de la photodiode D se trouve amplifié d'un facteur n sur le collecteur du transistor Q2.

Un tel amplificateur de courant, réalisé à partir de transistors bipolaires, présente une impédance d'entrée de l'ordre de 1 kohm, ce qui est satisfaisant *pour* amplifier des courants de l'ordre de 3 microampères avec une bande passante d'environ 1,5 mégahertz dans des cas courants où les capacités parasites sont relativement faibles.

Le document DE-A-3 140 956 vise un autre amplificateur à faible impédance d'entrée adapté à une tête de lecture.

Les circuits de traitement numérique du signal fourni par la photodiode D, notamment dans le cas du disque laser, sont généralement réalisés en technologie CMOS qui est de faible coût et bien adaptée au traitement numérique.

Un miroir de courant réalisé en technologie CMOS fournit des résultats nettement insuffisants pour amplifier des courants faibles avec une grande bande passante. En conséquence, dans les lecteurs de disques laser, les amplificateurs des courants des photodiodes de la tête de lecture sont réalisés en technologie bipolaire et ne peuvent être intégrés dans le même circuit que celui qui effectue le traitement du signal.

Un objet de la présente invention est de prévoir un amplificateur de courant ayant une impédance d'entrée particulièrement faible.

Un autre objet de la présente invention est de réaliser un tel amplificateur en technologie CMOS.

Ces objets sont atteints grâce à un amplificateur de courant comprenant
- un premier transistor MOS dont la source connectée à une entrée de l'amplificateur, et la prille connectée à une tension fixe ;
- une première source de courant constant reliée entre l'entrée et un premier potentiel d'alimentation ;
- une deuxième source de courant constant de valeur inférieure à celle de la première source, reliée entre un deuxième potentiel d'alimentation et le drain du premier transistor ;
- un deuxième transistor MOS de type différent de celui du premier transistor, relié entre l'entrée et le deuxième potentiel, et commandé par le noeud entre le premier transistor et la deuxième source de courant ; et
- un transistor de sortie MOS de même type que le deuxième transistor, relié au deuxième potentiel et commandé par ledit noeud.

La structure de l'amplificateur se distingue de l'etat de la technique selon la Fig. 2 en ce qu'il comprend le premier transistor et la deuxième source de courant.

Selon un mode de réalisation de la présente invention, les première et deuxième sources de courant constant sont formées par des transistors reliés par un circuit à miroir de courant.

Selon un mode de réalisation de la présente invention, les transistors sont des transistors MOS.

Selon un mode de réalisation de la présente invention, le courant d'entrée de l'amplificateur est fourni par une photodiode.

Selon un mode de réalisation de la présente invention, la photodiode est une photodiode d'une tête de lecture de disque laser, l'amplificateur étant intégré avec les circuits de traitement de signal du disque laser.

Ces objets, caractéristiques et avantages ainsi que d'autres de la présente invention seront exposés en détail dans la description suivante de modes de réalisation particuliers, faite à titre non-limitatif à l'aide des figures jointes parmi lesquelles :
la figure 1 représente une application classique d'un amplificateur de courant ;
la figure 2 représente une structure bipolaire classique d'un amplificateur de courant ;
la figure 3 représente un mode de réalisation d'amplificateur de courant selon la présente invention, réalisable en technologie CMOS ; et
la figure 4 représente un mode de réalisation détaillé de l'amplificateur selon la présente invention.

A la figure 3, un courant i à amplifier est fourni en A sur le drain d'un transistor MOS à canal N MN1 dont la source est reliée à la masse GND. La grille de ce transistor MN1 est reliée à la masse GND par une source de courant constant 14 qui draine un courant I. Un transistor MOS à canal P MP1 est relié par sa source et son drain au drain et à la grille, respectivement, du transistor MN1. La grille du transistor MP1 reçoit une tension fixe Vc. Une source de courant constant 16 relie la source du transistor MP1 à un potentiel d'alimentation haut Vcc. Cette source de courant 16 fournit un courant, par exemple égal à 2I, supérieur à celui de la source de courant 14. Un transistor MOS à canal N MN2 est relié en parallèle par sa grille et sa source sur le transistor MN1. Le courant de sortie de l'amplificateur est prélevé sur le drain du transistor MN2.

La source de courant 14 prélève un courant I de la source de courant 16 par le transistor MP1, et le surplus de courant (I) de la source de courant 16 ne peut passer que dans le transistor MN1. La tension aux bornes de la source de courant 14 (la tension grille-source du transistor MN1) s'établit à une valeur telle que le transistor MN1 absorbe ce surplus de courant I. Le transistor MN2, fonctionnant dans les mêmes conditions que le transistor MN1, recopie sur son drain le courant du transistor MN1. Bien entendu, cette recopie s'effectue avec un facteur multiplicatif n égal au rapport de surface des transistors MN2 et MN1.

Lorsqu'un courant i est injecté dans l'entrée A, la tension grille-source du transistor MP1 a tendance à augmenter, puisque la tension Vc est fixe. Ainsi, le transistor MP1 devient plus conducteur. Comme le courant de drain I de ce transistor est constant, il en résulte que la tension aux bornes de la source de courant 14 augmente. Cette augmentation de la tension rend le transistor MN1 plus conducteur, de manière que celui-ci absorbe le courant d'entrée i, ce qui rétablit la tension sur l'entrée A sensiblement à sa valeur initiale. Le transistor MN2, recopiant toujours le courant du transistor MN1, draine alors un courant n(I+i).

L'impédance d'entrée de l'amplificateur de courant selon l'invention a été mesurée à environ 100 ohms.

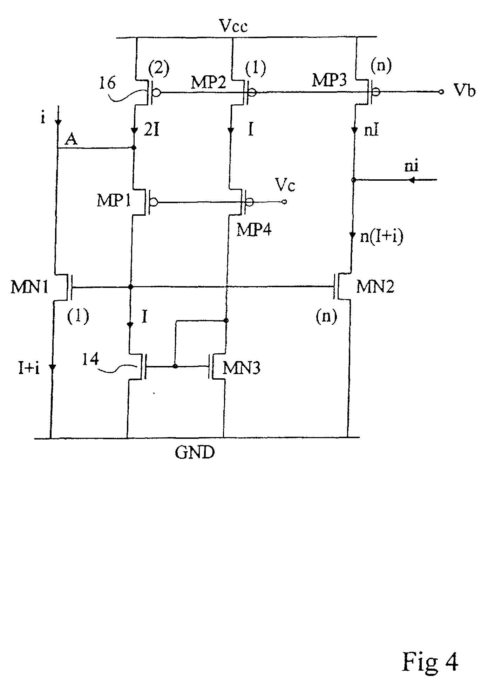

La figure 4 représente un mode de réalisation détaillé d'un amplificateur de courant selon l'invention. Des mêmes éléments qu'à la figure 3 sont désignés par des mêmes références. La source de courant 16 est formée par un transistor MOS à canal P dont la source est reliée au potentiel Vcc et dont le drain fournit le courant 2I. La grille du transistor 16 reçoit une tension de polarisation Vb. Cette tension Vb est en même temps appliquée sur les grilles de deux autres transistors MOS à canal P MP2 et MP3 reliés en parallèle sur le transistor 16 par leurs grilles et leurs sources. Les surfaces des transistors 16, MP2 et MP3 sont respectivement 2, 1 et n, de manière que ceux-ci fournissent respectivement des courants 2I, I et nI.

Le courant I fourni par le transistor MP2 arrive sur le drain et la grille d'un transistor MOS à canal N MN3 dont la source est reliée à la masse GND. Ce transistor MN3 est le transistor d'entrée d'un miroir de courant dont la sortie constitue la source de courant 14. Cette sortie comprend un transistor MOS à canal N 14 connecté en parallèle sur le transistor MN3 par sa grille et sa source.

Pour que les transistors MN3 et 14 fonctionnent dans les mêmes conditions, le transistor MN3 est relié au transistor MP2 par un transistor cascode à canal P MP4 recevant sur sa grille la tension Vc, comme le transistor cascode MP1.

Le drain du transistor MN2 reçoit le courant nI du transistor MP3, ce qui permet à l'amplificateur de soutirer par le drain du transistor MN2 le seul courant amplifié ni.

L'amplificateur de courant selon l'invention est avantageusement réalisé en technologie CMOS, ce qui permet son intégration avec un circuit numérique de traitement de signal, notamment des signaux provenant des photodiodes d'une tête de lecture de disque laser. Toutefois, dans d'autres applications, l'amplificateur selon l'invention pourra aussi être réalisé en technologie bipolaire.

## Revendications

1. Amplificateur de courant, comprenant :
- un premier transistor MOS (MP1) dont la source connectée à une entrée (A) de l'amplificateur, et la grille connectée à une tension fixe (Vc) ;
- une première source de courant constant (16) reliée entre l'entrée et un premier potentiel d'alimentation (Vcc) ;
- une deuxième source de courant constant (14) de valeur inférieure à celle de la première source, reliée entre un deuxième potentiel d'alimentation (GND) et le drain du premier transistor;
- un deuxième transistor MOS (MN1) de type différent de celui du premier transistor, relié entre l'entrée et le deuxième potentiel, et commandé par le noeud entre le premier transistor et la deuxième source de courant ; et
- un transistor de sortie MOS (MN2) de même type que le deuxième transistor, relié au deuxième potentiel et commandé par ledit noeud.

2. Amplificateur de courant selon la revendication 1, **caractérisé en ce que** les première et deuxième sources de courant constant sont formées par des transistors (16, 14) reliés par un circuit à miroir de courant (MP2, MN3).

3. Amplificateur de courant selon l'une des revendications 1 et 2, **caractérisé en ce que** les transistors sont remplacés par des transistors bipolaires.

4. Amplificateur de courant selon l'une des revendication 1 et 2, **caractérisé en ce que** son courant d'entrée est fourni par une photodiode (D).

5. Amplificateur de courant selon la revendication 4, **caractérisé en ce que** la photodiode est une photodiode d'une tête de lecture de disque laser, l'amplificateur étant intégré avec les circuits de traitement de signal du disque laser.

## Patentansprüche

1. Stromverstärker, welcher umfaßt:
- einen ersten MOS-Transistor (MP1), dessen Source-Anschluß mit einem Eingang (A) des Verstärkers und dessen Gate mit einer Festspannung (Vc) verbunden sind,
- eine zwischen dem Eingang und einem ersten Speisepotential (Vcc) angeschlossene erste Konstantstromquelle (16),
- eine zweite Konstantstromquelle (14), deren Betrag kleiner als der der ersten Quelle ist und die zwischen einem zweiten Speisepotential (GND) und dem Drain-Anschluß des ersten Transistors angeschlossen ist,
- einen zweiten MOS-Transistor (MN1) eines von dem Typ des ersten Transistors verschiedenen Typs, der zwischen dem Eingang und dem zweiten Potential angeschlossen ist und durch den Knotenpunkt zwischen dem ersten Transistor und der zweiten Stromquelle gesteuert wird, sowie
- einen Ausgangs-MOS-Transistor (MN2) des gleichen Typs wie der zweite Transistor, der mit dem zweiten Potential verbunden ist und durch den genannten Knotenpunkt gesteuert wird.

2. Stromverstärker nach Anspruch 1,
**dadurch gekennzeichnet, daß** die erste und die zweite Konstantstromquelle von Transistoren (16, 14) gebildet werden, die jeweils mit einer Stromspiegel-Schaltung (MP2, MN3) verbunden sind.

3. Stromverstärker nach einem der Ansprüche 1 und 2,
**dadurch gekennzeichnet, daß** die Transistoren durch BipolarTransistoren ersetzt sind.

4. Stromverstärker nach einem der Ansprüche 1 und 2,
**dadurch gekennzeichnet, daß** sein Eingangsstrom von einer Photodiode (D) geliefert wird.

5. Stromverstärker nach Anspruch 4,
**dadurch gekennzeichnet, daß** die Photodiode eine Photodiode eines Lesekopfs einer Laser-Diskette bzw. CD ist und daß der Verstärker mit den Signal-Verarbeitungsschaltungen der Laser-Diskette bzw. CD integriert ist.

## Claims

1. A current amplifier including:
a first MOS transistor (MP1) having a source connected to an input (A) of the amplifier, and a gate connected to a fixed voltage (Vc);
a first constant current source (16) connected between the input and a first supply voltage (Vcc);
a second constant current source (14), for providing a current lower than the first current source, connected between a second supply voltage (GND) and the drain of the first transistor;
a second (MOS) transistor (MN1), of different type than the first transistor, connected between the input and the second supply voltage, and controlled by the node between the first transistor and the second current source; and
an output MOS transistor (MN2) of same type as the second transistor, connected to the second supply voltage and controlled by said node.

2. The current amplifier of claim 1, **characterized in that** the first and second constant current sources are formed by transistors (16, 14) connected through a current mirror circuit (MP2, MN3).

3. The current amplifier of claim 1 or 2, **characterized in that** said transistors are replaced by bipolar transistors.

4. The current amplifier of claim 1 or 2, **characterized in that** its input current is generated by a photodiode (D).

5. The current amplifier of claim 4, **characterized in that** said photodiode is a photodiode of a CD read head, the amplifier being integrated with CD signal processing circuitry.
